# EUROPÄISCHE PATENTSCHRIFT

(11) **EP 1 586 544 B1**
(45) Veröffentlichungstag und Bekanntmachung des Hinweises auf die Patenterteilung: **02.12.2009**
(21) Anmeldenummer: 05006523.4
(22) Anmeldetag: 24.03.2005
(51) Int. Cl.: C03C 3/06, C03C 4/00, C03B 19/14, G02B 1/00, G03F 7/20

(54) **Optisches Bauteil aus Quarzglas, Verfahren zur Herstellung des Bauteils und Verwendung desselben**
Optical element made from silica glass, method of its manufacture and its use
Element optique en verre quartzeux, son procédé de fabrication et son utilisation

(30) Priorität: 02.04.2004 DE 102004017031
(43) Veröffentlichungstag der Anmeldung: 19.10.2005
(73) Patentinhaber: Heraeus Quarzglas GmbH & Co. KG, 63450 Hanau (DE)
(72) Erfinder: Kühn, Bodo, 63450 Hanau (DE); Thomas, Stephan, 63538 Grosskrotzenburg (DE); Kaiser, Steffen, 63456 Hanau (DE)
(74) Vertreter: Staudt, Armin Walter

(56) Entgegenhaltungen:
- EP-A- 0 546 196
- PATENT ABSTRACTS OF JAPAN Bd. 018, Nr. 219 (C-1192), 20. April 1994 (1994-04-20) -& JP 06 016449 A (SHINETSU QUARTZ PROD CO LTD), 25. Januar 1994 (1994-01-25)

## Beschreibung

Die Erfindung betrifft ein optisches Bauteil aus Quarzglas zur Übertragung ultravioletter Strahlung einer Wellenlänge zwischen 190 nm und 250 nm mit einer Glasstruktur im wesentlichen ohne Sauerstoffdefektstellen, einem Wasserstoffgehalt im Bereich von 0,1 x 10¹⁶ Molekülen/cm³ bis 5,0 x 10¹⁶ Molekülen/cm³ und einem Gehalt an SiH-Gruppen von < 5 x 10¹⁶ Molekülen/cm³.

Weiterhin betrifft die Erfindung ein Verfahren zur Herstellung eines derartigen optischen Bauteils aus Quarzglas und seine Verwendung.

Verfahren zur Herstellung von synthetischem Quarzglas durch Oxidation oder durch Flammenhydrolyse siliziumhaltiger Ausgangssubstanzen sind unter den Bezeichnungen VAD-Verfahren (Vapor Phase Axial Deposition), OVD Verfahren (Outside Vapor Phase Deposition), MCVD Verfahren (Modified Chemical Vapor Deposition) und PCVD Verfahren (oder auch PECVD-Verfahren; Plasma Enhanced Chemical Vapor Deposition) allgemein bekannt. Bei allen diesen Verfahrensweisen werden in der Regel mittels eines Brenners SiO₂-Partikel erzeugt und schichtweise auf einem Träger abgeschieden, der sich relativ zu einer Reaktionszone bewegt. Bei hinreichend hoher Temperatur im Bereich der Trägeroberfläche kommt es zu einem unmittelbaren Verglasen der SiO₂-Partikel ("Direktverglasen"). Im Unterschied dazu ist bei dem sogenannten "Sootverfahren" die Temperatur während des Abscheidens der SiO₂-Partikel so niedrig, dass eine poröse Sootschicht erhalten wird, die in einem separaten Verfahrensschritt zu transparentem Quarzglas gesintert wird. Sowohl das Direktverglasen als auch das Sootverfahren führen zu einem dichten, transparenten, hochreinen, synthetischen Quarzglas in Form von Stäben, Blöcken, Rohren oder Platten, die zu optischen Bauteilen, wie Linsen, Fenstern, Filtern, Maskenplatten, für den Einsatz zum Beispiel in der Mikrolithographie, weiter verarbeitet werden.

In der EP-A 401 845 sind Verfahren zur Herstellung plattenförmiger Quarzglasrohlinge durch Direktverglasen und nach dem Sootverfahren beschrieben. Um mechanische Spannungen innerhalb der Rohlinge abzubauen und eine homogene Verteilung der fiktiven Temperatur zu erreichen, werden diese üblicherweise sorgfältig getempert. Es wird ein Temperprogramm vorgeschlagen, bei dem der Rohling einer 50-stündigen Haltezeit bei einer Temperatur von etwa 1100 °C unterworfen wird und abschließend in einem langsamen Abkühlschritt mit einer Abkühlrate von 2 °/h auf 900 °C und dann im geschlossenen Ofen auf Raumtemperatur abgekühlt wird.

Ein ähnliches Verfahren zur Herstellung eines Bauteils aus synthetischem Quarzglas für den Einsatz in der Mikrolithographie nach dem Sootverfahren ist auch aus der EP 1 125 897 A1 bekannt.

Ein Quarzglasrohling für ein optisches Bauteil der eingangs genannten Gattung ist in der DE 101 59 961 C2 beschrieben. Derartige Optische Bauteile aus Quarzglas werden für die Übertragung energiereicher, ultravioletter Laserstrahlung beispielsweise in Form von Belichtungsoptiken in Mikrolithographiegeräten für die Herstellung hochintegrierter Schaltungen in Halbleiterchips eingesetzt. Die Belichtungssysteme moderner Mikrolithographiegeräte sind mit Excimerlasern bestückt, die energiereiche, gepulste UV-Strahlung einer Wellenlänge von 248 nm (KrF-Laser) oder von 193 nm (ArF-Laser) abgeben.

In der EP 0 546 196 A wird ein optisches Bauteil aus Quarzglas für die Mikrolithographie beschrieben, bei dem der Wasserstoffgehalt des Quarzglases bei weniger als 1 x 10¹⁶ Molekülen/cm³ und der Hydroxylgruppengehalt im Bereich zwischen 10 und 100 ppm liegen sollen. Es wird die Einstellung einer möglichst einheitlichen fiktiven Temperatur angestrebt. Das aus der EP 0 546 196 A zu entnehmende Verfahren zur Herstellung des optischen Bauteils zeichnet sich durch ein Tempern eines Quarzglasrohlings mit vergleichsweise geringer Abkühlrate aus. Gemäß dem Ausführungsbeispiel 1 wird das zu tempernde Quarzglas 20 Stunden bei 1100 °C gehalten und danach mit einer Abkühlrate von 0,5 °C/min auf 600 °C abgekühlt.

Bei mikrolithographischen Projektionsbelichtungsanlagen besteht allgemein die Forderung, dass eine im Bereich einer Pupillenebene des Beleuchtungssystems bereitgestellte Lichtverteilung möglichst homogen und winkelerhaltend in eine zur Pupillenebene des Beleuchtungssystems konjugierte Pupillenebene des Projektionsobjektivs übertragen werden sollte. Jede im Lichtweg erzeugte Veränderung des Winkelspektrums führt zu einer Verzerrung der Intensitätsverteilung in der Objektivpupille, was zu einer unsymmetrischen Einstrahlung und damit zu einer Verschlechterung der Abbildungsleistung führt. Linear polarisierende Lichtquellen, wie zum Beispiel Excimer-Laser, zeigen in der Regel einen Polarisationsgrad von ca. 90 bis 95 %. Mittels einer λ/4-Platte wird das Licht zirkular polarisiert und soll idealerweise in diesem zirkularen Zustand bis zu dem zu belichtenden Wafer erhalten werden.

In dem Zusammenhang spielt die Doppelbrechung eine wichtige Rolle, da diese die Abbildungstreue optischer Bauteile aus Quarzglas beeinträchtigt. Spannungsdoppelbrechung in Quarzglas entsteht beispielsweise beim inhomogenen Abkühlen des Rohlings für das herzustellende optische Bauteil oder durch die UV-Bestrahlung selbst.

In jüngster Zeit werden Experimente mit Projektionssystemen durchgeführt, die mit der Technik der sogenannten "Immersions-Lithographie" arbeiten. Dabei ist der Spalt zwischen der Bildebene und dem letzten optischen Bauteil des Linsensystems mit einer Flüssigkeit (üblicherweise deionisiertes Wasser) mit höherer Brechzahl als Luft, idealerweise mit der Brechzahl des Quarzglases bei der Einsatzwellenlänge, gefüllt. Die höhere Brechzahl der Flüssigkeit gegenüber Luft bewirkt eine größere numerische Apertur des optischen Bauteils und verbessert dadurch die Abbildungseigenschaften. Allerdings ist die "Immersions-Lithographie" polarisationsempfindlich; die besten Ergebnisse werden erhalten, wenn mit linear polarisierte Laserstrahlung gearbeitet wird - und nicht wie sonst üblich, mit vollständig oder teilweise zirkular polarisierter Laserstrahlung. In "N.F. Borelli, C.M. Smith, J.J. Price, D.C. Allan "Polarized excimer laser-induced birefringence in silica", Applied Physics Letters, Vol. 80, No. 2, (2002), p. 219-221" ist beschrieben, dass der Einsatz von linear polarisierter UV-Laserstrahlung zu einer schwerwiegenden Schädigung der Glasstruktur des optischen Quarzglas-Bauteils führt, die im Folgenden näher erläutert wird.

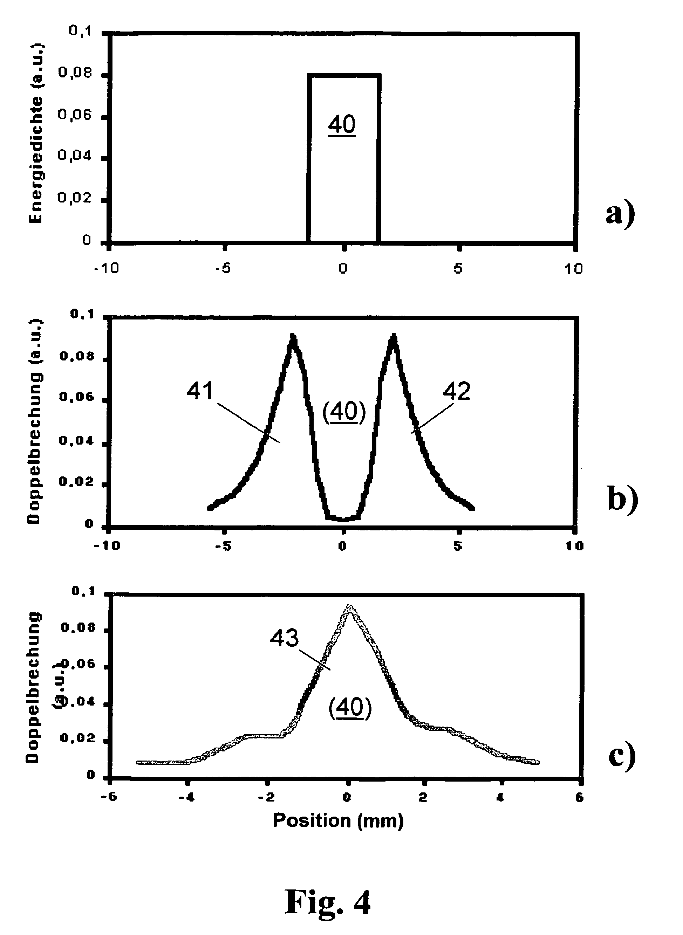

Die sogenannte "Kompaktierung" des Quarzglases nach Bestrahlung mit kurzwelliger UV-Strahlung äußert sich in einer lokalen Dichteerhöhung des Glases in dem durchstrahlten Volumen. Diese führt zu einem lokal inhomogenen Anstieg des Brechungsindex und damit zu einer Verschlechterung der Abbildungseigenschaften des optischen Bauteils. Es hat sich nun gezeigt, dass zirkular polarisierte UV-Strahlung eine eher isotrope Dichteänderung bewirkt, und linear polarisierte UV-Strahlung eine eher anisotrope Dichteänderung. Anhand Figur 4 wird der Unterschied erläutert.

Das Diagramm **Figur 4a****)** zeigt schematisch ein Volumenelement 40 (symbolisiert durch seine Position und Ausdehnung auf der x-Achse), das mit UV-Strahlung einer Energiedichte von 0,08 (in relativen Einheiten) bestrahlt wird (kreisförmiger Bestrahlfleck).

In **Figur 4b****)** ist das Ergebnis der Bestrahlung bei Einsatz zirkular polarisierter UV-Strahlung dargestellt. Nach der Bestrahlung ist die Dichte des bestrahlten Volumenelement insgesamt höher als die Dichte des umgebenden Quarzglases (isotrope Dichteänderung). Im Bereich des Übergangs zwischen verdichtetem und nicht verdichtetem Material entstehen daher Spannungen, die sich optisch als Spannungsdoppelbrechung äußeren. In der zweidimensionalen Darstellung von Figur 4b sind diese Spannungen um den Rand des kreisfömigen Bestrahlflecks als Maxima 41, 42 der Spannungsdoppelbrechung dargestellt. In einer Draufsicht auf das Volumenelement 40 gehören die Maxima 41, 42 zu einem um das Volumen 40 verlaufenden Ring. Diese einmal erzeugte isotrope Dichte- und Brechzahländerung (Spannungsdoppelbrechung) bewirkt eine Veränderung der Abbildungseigenschaften der Linse. Aufgrund ihrer Kreissymmetrie wirkt sich diese Veränderung während des späteren Einsatz des Bauteils jedoch im Wesentlichen gleich aus; sie ist daher kalkulierbar.

Im Unterschied dazu führt eine Bestrahlung des Volumenelementes 40 mit linear polarisierter UV-Laserstrahlung zu einer anisotropen Dichteänderung, wie sie in **Figur 4c**) angedeutet ist. Hierbei wird ein Maximum der Dichteänderung - und damit auch ein Maximum 43 der dadurch erzeugten Doppelbrechung - erzeugt, das eine Vorzugsrichtung in Richtung des Polarisationsvektors der einfallenden UV-Strahlung zeigt. Die dadurch erzeugte, anisotrope Dichte- und Brechzahländerung ist nicht im Wesentlichen radialsymmetrisch, und bewirkt ebenfalls eine Veränderung der Abbildungseigenschaften des Bauteils. Diese wirkt sich insbesondere bei einem Wechsel der Polarisationsrichtung der eingestrahlten UV-Strahlung - was im Verlauf der Lebensdauer des Bauteils zu erwarten ist - ungünstig aus, da ihr Einfluss auf die Abbildung kaum kalkulierbar ist. Ein derartig vorgeschädigtes Quarzglas-Bauteil ist daher für andere Einsatzbereiche kaum noch brauchbar, was die Lebensdauer des optischen Bauteils beschränkt.

Der Erfindung liegt daher die Aufgabe zugrunde, ein optisches Bauteil bereit zu stellen, das für den Einsatz mit linear polarisierter UV-Laserstrahlung besonders gut geeignet ist, und das auch nach einem Einsatz mit linear polarisierter Strahlung noch variabel einsetzbar ist. Außerdem liegt der Erfindung die Aufgabe zugrunde, ein Verfahren zur Herstellung eines derartigen optischen Bauteils und eine besondere Verwendung dafür anzugeben.

Hinsichtlich des optischen Bauteils wird diese Aufgabe erfindungsgemäß durch eine Ausführungsform des Bauteils gelöst, das die Kombination folgender Eigenschaften aufweist:
■ eine Glasstruktur im wesentlichen ohne Sauerstoffdefektstellen,
■ einen H₂-Gehalt im Bereich von 0,1 x 10¹⁶ Molekülen/cm³ bis 5,0 x 10¹⁶ Molekülen/cm³,
■ einen Gehalt an SiH-Gruppen von weniger als 5 x 10¹⁶ Molekülen/cm³
■ einen Gehalt an Hydroxylgruppen im Bereich zwischen 10 und maximal 250 Gew.-ppm und
■ eine fiktive Temperatur von 1035 °C oder höher.

Idealerweise sind die Eigenschaften (fiktive Temperatur) über das genutzte Volumen des optischen Bauteils konstant und die angegebenen Komponenten gleichmäßig verteilt. Die oben genannten Konzentrations- und Temperaturangaben sind Mittelwerte innerhalb des optisch genutzten Bereichs des Bauteils (auch bezeichnet als "CA-Bereich" (clear aperture) oder "optisch genutztes Volumen").

Unter einer Glasstruktur, die im wesentlichen frei von Sauerstoffdefektstellen ist, wird hier eine Glasstruktur verstanden, bei der die Konzentrationen von Sauerstoff-Unterschussdefekten und von Sauerstoff-Überschussdefekten unterhalb der Nachweisbarkeitsgrenze der Methode von Shelby liegen. Diese Nachweismethode ist veröffentlicht in "Reaction of hydrogen with hydroxyl-free vitreous silica" (J. Appl. Phys., Vol. 51, No. 5 (Mai 1980), S. 2589-2593). Quantitativ ergibt sich dabei eine Anzahl an Sauerstoff-Unterschussdefekten oder an Sauerstoff-Überschussdefekten in der Glasstruktur von nicht mehr als etwa 10¹⁷ pro Gramm Quarzglas.

Der Wasserstoffgehalt (H₂-Gehalt) wird anhand einer Raman-Messung ermittelt, die erstmals von Khotimchenko et al. vorgeschlagen worden ist ("Determining the Content of Hydrogen Dissolved in Quartz Glass Using the Methods of Raman Scattering and Mass Spectrometry" Zhurnal Prikladnoi Spektroskopii, Vol. 46, No. 6 (Juni 1987), S. 987-991).

Der Gehalt an SiH-Gruppen wird mittels Raman-Spektroskopie ermittelt, wobei eine Kalibrierung anhand einer chemischen Reaktion erfolgt: Si-O-Si + H2 → Si-H + Si-OH, wie in Shelby "Reaction of hydrogen with hydroxyl-free vitreous silica" (J. Appl. Phys., Vol. 51, No. 5 (Mai 1980), S. 2589-2593) beschrieben.

Der Hydroxylgruppengehalt (OH-Gehalt) ergibt sich durch Messung der IR-Absorption nach der Methode von D. M. Dodd et al. ("Optical Determinations of OH in Fused Silica", (1966), S. 3911).

Bei der fiktiven Temperatur handelt es sich um einen Parameter, der die spezifische Netzwerkstruktur des Quarzglases charakterisiert. Ein gängiges Messverfahren zur Ermittlung der fiktiven Temperatur anhand einer Messung der Raman-Streuintensität bei einer Wellenzahl von etwa 606 cm⁻¹ ist in "Ch. Pfleiderer et. al; "The UV-induced 210 nm absorption band in fused Silica with different thermal history and stoichiometry"; J. Non-Cryst. Solids 159 (1993) 145-143" beschrieben.

Gegenüber dem aus der DE 101 59 961 C2 beschriebenen Quarzglas zeichnet sich das Quarzglas des erfindungsgemäßen optischen Bauteils durch einen vergleichsweise geringen OH-Gehalt, und insbesondere durch eine hohe fiktive Temperatur aus.

Es hat sich überraschend gezeigt, dass ein optisches Bauteil, das aus einem Quarzglas mit den oben genannten Eigenschaften gefertigt wird, eine nur geringe anisotrope Dichteänderung beim Einsatz mit linear polarisierter UV-Laserstrahlung erfährt.

Dies wird auf den vergleichsweise niedrigen Hydroxylgruppengehalt des Quarzglases und seine relativ hohe fiktive Temperatur zurückgeführt. Mit abnehmendem Hydroxylgruppengehalt eines Quarzglases nimmt dessen Viskosität zu. Zum anderen ist bekannt, dass aus dem Temperaturbereich zwischen 1000 °C und 1500 °C rasch abgekühltes Quarzglas (mit einer hohen fiktiven Temperatur) ein geringeres spezifisches Volumen und damit eine höhere spezifische Dichte aufweist, als langsam abgekühltes Quarzglas (mit einer niedrigen fiktiven Temperatur). Dieser Effekt beruht laut "R. Brückner, Silicon Dioxide; Encyclopedia of Applied Physics, Vol. 18 (1997), S. 101-131", auf einer Anomalie von synthetischem Quarzglas, bei dem der Verlauf des spezifischen Volumens im Bereich zwischen 1000 °C und 1500 °C einen negativen Temperaturkoeffizienten aufweist; das heißt, dass das spezifische Volumen von Quarzglas in diesem Temperaturbereich mit abnehmender Temperatur zunimmt, oder anders ausgedrückt, dass aus dem genannten Temperaturbereich schnell abgekühltes Quarzglas - mit einer hohen fiktiven Temperatur - eine höhere Dichte aufweist als langsam abgekühltes Quarzglas mit einer niedrigeren fiktiven Temperatur.

Die infolge der höheren fiktiven Temperatur gleichzeitig höhere Dichte des Quarzglases wirkt wie "eine vorweggenommene" Kompaktierung der Glasstruktur insgesamt. Insoweit wirkt die kompakte Netzwerkstruktur dem Effekt einer lokalen Kompaktierung bei UV-Bestrahlung entgegen. Es wurde gefunden, dass so der auf eine isotrope Dichteänderung zurückzuführende Anteil einer Kompaktierung verringert werden kann, und es ist zu erwarten, dass sich dadurch auch die Gefahr einer anisotropen Dichteänderung gegenüber linear polarisierter UV-Strahlung verringert.

Außer der höheren Viskosität kann dem geringen OH-Gehalt noch eine andere Bedeutung hinsichtlich der Vermeidung einer anisotropen Dichteänderung zukommen. Es ist zu vermuten, dass die Dichteänderung mit einer Umlagerung von Hydroxylgruppen einhergeht, wobei dieser Umlagerungsmechanismus um wahrscheinlicher und leichter abläuft, je mehr Hydroxylgruppen zur Verfügung stehen. Der geringe Hydroxylgruppengehalt als auch die höhere Dichte (hohe fiktive Temperatur) des Quarzglases verringern daher die Empfindlichkeit der Glasstruktur gegenüber einer lokalen anisotropen Dichteänderung. Das erfindungsgemäße Quarzglas-Bauteil widersteht der Kompaktierungswirkung von UV-Strahlung somit besser als die bekannten Quarzglas-Qualitäten, so dass es insbesondere für den Einsatz zur Übertragung linear polarisierter UV-Strahlung einer Wellenlänge zwischen 190 nm und 250 nm besonders gut geeignet ist.

Es hat sich als besonders vorteilhaft erwiesen, wenn das Quarzglas eine fiktive Temperatur oberhalb von 1050 °C, vorzugsweise oberhalb von 1100 °C, aufweist.

Je höher die fiktive Temperatur des Quarzglases ist, um so höher ist seine Dichte und um so ausgeprägter die oben beschriebene Wirkung der "vorweggenommenen" Kompaktierung des Quarzglases insgesamt, und damit der Widerstand gegen eine lokale anisotrope Dichteerhöhung durch linear polarisierte UV-Strahlung. Bei sehr hohen fiktiven Temperaturen (>1200 °C) kann dieser positive Effekt jedoch durch eine zu hohe thermisch bedingte Spannungsdoppelbrechung beeinträchtigt werden.

Im Hinblick auf eine hohe Viskosität des Quarzglases wird eine Ausführungsform des optischen Bauteils bevorzugt, bei dem das Quarzglas einen Gehalt an Hydroxylgruppen zwischen 30 bis 200 Gew.-ppm, vorzugsweise unterhalb von 125 Gew.-ppm aufweist.

Der geringe Hydroxylgruppengehalt bewirkt eine Erhöhung der Viskosität. Die damit einhergehende Verbesserung des Verhaltens gegenüber einer lokalen anisotropen Dichteänderung ist insoweit überraschend, als in der oben erwähnten DE 101 59 961 C2 angenommen wird, dass ein Quarzglas mit einem Hydroxylgruppengehalt von weniger als 125 Gew.-ppm, wie sie für das nach dem Sootverfahren hergestellte Quarzglas typisch sind, zu Kompaktierung neigt.

Die viskositätserhöhende Wirkung des vergleichsweise geringen Hydroxylgruppengehalts kann durch einen hohen Fluorgehalt ganz oder teilweise aufgehoben werden. Daher weist das Quarzglas für das erfindungsgemäße optische Bauteil bevorzugt einen Gehalt an Fluor von weniger als 100 Gew.-ppm auf. Fluor verringert außerdem die Brechzahl von Quarzglas, so dass die Einsatz-Variabiltät bei einem mit Fluor dotierten Quarzglases (≥100 Gew.-ppm) verringert ist.

Hinsichtlich des Verfahrens wird die oben angegebene Aufgabe erfindungsgemäß durch ein Verfahren gelöst, das die folgenden Verfahrensschritte umfasst:
- Herstellen eines SiO₂-Sootkörpers,
- Verglasen des Sootkörpers unter Vakuum unter Bildung eines zylinderförmigen Quarzglasrohlings mit einem Hydroxylgruppengehalt im Bereich zwischen 10 und maximal 250 Gew.-ppm, vorzugsweise zwischen 30 bis 200 Gew.-ppm, und besonders bevorzugt unterhalb von 125 Gew.-ppm.
- Tempern des Quarzglasrohlings unter Bildung eines Quarzglas-Zylinders, mit einer fiktiven Temperatur von 1035 °C oder höher, der eine Kontur des herzustellenden optischen Bauteils mit Übermaß umgibt, wobei das Tempern ein Halten des Quarzglasrohlings während einer ersten Haltezeit von mindestens 4 Stunden bei einer ersten, höheren Tempertemperatur, die mindestens 50 °C oberhalb der einzustellenden fiktiven Temperatur des Quarzglas-Bauteils liegt, ein Abkühlen mit einer ersten, geringeren Abkühlrate auf eine zweite, niedrigere Tempertemperatur, die im Bereich zwischen +/- 20 °C um die einzustellende fiktiven Temperatur des Quarzglas-Bauteils liegt, ein Halten bei der niedrigeren Tempertemperatur während einer zweiten Haltezeit, und ein Abkühlen auf eine vorgegebene Endtemperatur unterhalb von 800 °C, vorzugsweise unterhalb von 400 °C, mit einer zweiten, höheren Abkühlrate, die mindestens 25°C/h beträgt, umfasst,
- Abnehmen eines Teils des axialen Übermaßes im Bereich der Stirnflächen des Quarzglas-Zylinders,
- Beladen des Quarzglas-Zylinders mit Wasserstoff durch Erhitzen in einer Wasserstoff enthaltenden Atmosphäre bei einer Temperatur unterhalb von 500 °C unter Erzeugung eines mittleren Wasserstoffgehalts im Bereich von 0,1 x 10¹⁶ Molekülen/cm³ bis 5,0 x 10¹⁶ Molekülen/cm³.

Durch "Direktverglasen" wird üblicherweise Quarzglas mit einem OH-Gehalt von 450 bis 1200 Gew.-ppm erhalten, wogegen für Quarzglas, das nach dem nach dem "Sootverfahren" hergestellt wird, eher geringe OH-Gehalte im Bereich einiger Gew.-ppm- bis 300 Gew.-ppm typisch sind. Das Quarzglas für das erfindungsgemäße optische Bauteil wird daher bevorzugt mittels "Sootverfahren" hergestellt. Dabei wird als Zwischenprodukt ein SiO₂-Sootkörper erzeugt, dessen Hydroxylgruppengehalt auf einfache Art und Weise durch die Dauer und Intensität einer Dehydratationsbehandlung auf einen vorgegebenen Wert eingestellt werden kann.

Der Sootkörper wird unter Vakuum unter Bildung eines zylinderförmigen Quarzglasrohlings verglast. Durch das Vakuum wird molekularer Wasserstoff entfernt, der beim Flammhydrolyseverfahren herstellungsbedingt in das Quarzglas eingebracht wird, und der andernfalls bei nachfolgenden Heißbehandlungsschritten zu unerwünschten SiH-Gruppen weiter reagieren würde, die sich im Verlauf der weiteren Bearbeitungsschritte nachteilig bemerkbar machen und zu einer Verschlechterung des Schädigungsverhaltens des Quarzglas-Bauteils führen würden. Das Vakuum dient zur Beschleunigung des Ausgasungsvorgangs.

Nach dem Verglasen liegt ein Quarzglasrohling mit einem Hydroxylgruppengehalt im Bereich zwischen 10 und maximal 250 Gew.-ppm, vorzugsweise zwischen 30 bis 200 Gew.-ppm, und besonders bevorzugt unterhalb von 125 Gew.-ppm, vor, der im Wesentlichen frei von SiH-Gruppen und von Wasserstoff (der Gehalt beider Komponenten liegt unterhalb der Nachweisgrenze).

Der Quarzglasrohling wird anschließend getempert, wobei auf die Einstellung einer fiktiven Temperatur von 1035 °C oder höher, vorzugsweise oberhalb von 1050 °C, und besonders bevorzugt oberhalb von 1100 °C geachtet wird. Die vorgegebene fiktive Temperatur kann erhalten werden, indem der Quarzglasrohling bei einer Temperatur im Bereich der gewünschten fiktiven Temperatur bis zur Einstellung des strukturellen Gleichgewichtes gehalten und danach rasch abgekühlt wird, oder indem der Rohling von einer Temperatur oberhalb der einzustellenden fiktiven Temperatur ausreichend schnell abgekühlt wird. Dabei ist einerseits darauf zu achten, dass die gewünschte hohe fiktive Temperatur erhalten und andererseits keine Spannungsdoppelbrechung erzeugt wird. Der einen Voraussetzung (hohe fiktive Temperatur) wird durch die Untergrenze einer Abkühlrate und der anderen Voraussetzung (geringe Spannungsdoppelbrechung) durch eine entsprechende Untergrenze Rechnung getragen, die weiter unten näher erläutert wird.

Infolge der Einstellung einer vergleichsweise hohen fiktiven Temperatur weist der erhaltene Quarzglas-Zylinder Restspannungen auf, die sich vor allem im rascher abkühlenden Randbereich des Bauteils bemerkbar machen. Daher wird von beiden Stirnseiten des Zylinders ein Bereich abgetragen, der zu dem Übermaß gehört, das die Kontur des herzustellenden optischen Bauteils umgibt. Durch das vorherige Abtragen dieses Übermaßes (oder eines Teils davon) wird die Beladungsdauer beim anschließenden Beladen des Quarzglas-Zylinders mit Wasserstoff verkürzt, die zur Einstellung eines mittleren Wasserstoffgehalts im Bereich von 0,1 x 10¹⁶ Molekülen/cm³ bis 5,0 x 10¹⁶ Molekülen/cm³ erforderlich ist.

Es ist bekannt, dass Wasserstoff eine ausheilende Wirkung in Bezug auf Defekte aufweist, die durch UV-Bestrahlung in Quarzglas entstehen. Beim erfindungsgemäßen Verfahren wird der Wasserstoffgehalt jedoch stark reduziert, zum Beispiel infolge der oben erläuterten Vakuumbehandlung des Sootkörpers. Daher wird das Quarzglas nachträglich mit Wasserstoff beladen. Die Wasserstof-Beladung erfolgt bei niedriger Temperatur unterhalb von 500 °C, um die Ausbildung von SiH-Gruppen zu reduzieren. SiH-Gruppen in Quarzglas sind unerwünscht, da aus ihnen bei Bestrahlung mit energiereichem UV-Licht ein sogenanntes E'-Zentrum und atomarer Wasserstoff entstehen. Das E'-Zentrum bewirkt eine erhöhte Absorption bei einer Wellenlänge von 210 nm und macht sich auch im angrenzenden UV-Wellenlängenbereich ungünstig bemerkbar. Thermodynamisch bedingt entstehen bei höheren Temperaturen (500 °C - 800 °C) in Gegenwart von Wasserstoff verstärkt SiH-Gruppen, wobei auch der vergleichsweise geringe OH-Gehalt des Quarzglases das Gleichgewicht in Richtung einer SiH-Bildung verlagert.

Das Tempern des Quarzglasrohlings dient in erster Linie zum Abbau von Spannungen, zur Einstellung der gewünschten fiktiven Temperatur, und damit einer kompaktierungsresistenten Glasstruktur, und umfasst erfindungsgemäß folgende Verfahrensschritte:
- ein Halten des Quarzglasrohlings während einer ersten Haltezeit von mindestens 4 Stunden bei einer ersten, höheren Tempertemperatur, die mindestens 50 °C oberhalb der einzustellenden fiktiven Temperatur des Quarzglas-Bauteils liegt,
- ein Abkühlen mit einer ersten, geringeren Abkühlrate auf eine zweite, niedrigere Tempertemperatur, die im Bereich zwischen +/- 20 °C um die einzustellende fiktiven Temperatur des Quarzglas-Bauteils liegt,
- ein Halten bei der niedrigeren Tempertemperatur während einer zweiten Haltezeit, und
- ein Abkühlen auf eine vorgegebene Endtemperatur unterhalb von 800 °C, vorzugsweise unterhalb von 400 °C, mit einer zweiten, höheren Abkühlrate, die mindestens 25°C/h beträgt.

Es hat sich gezeigt, dass einhergehend mit einer hohen fiktiven Temperatur eine vergleichsweise dichte Netzwerkstruktur erzeugt wird, die einer weiteren - lokalen - Kompaktierung durch UV-Bestrahlung, und insbesondere eine anisotropen Dichteänderung durch linear polarisierte UV-Strahlung entgegenwirkt. Das oben genannte, bevorzugte Temperprogramm beinhaltet ein Erhitzen auf eine Temperatur deutlich oberhalb der fiktiven Temperatur (> 50 °C), ein Abkühlen auf eine Temperatur im Bereich um die einzustellende fiktive Temperatur, und daraufhin ein vergleichsweise rasches Abkühlen des Quarzglasrohlings auf eine niedrige Temperatur, unterhalb der keine wesentlichen Änderungen des Glasstruktur mehr zu erwarten sind.

Es handelt sich hierbei um ein vergleichsweise kurzes Temperverfahren, was zwar Nachteile hinsichtlich der Spannungsdoppelbrechung mit sich bringen könnte, jedoch eine größere Stabilität gegenüber einer lokalen Kompaktierung durch UV-Strahlung bewirkt und neben der Zeitersparnis den weiteren Vorteil hat, dass wegen der vergleichsweise kurzen Behandlungsdauer bei hoher Temperatur die Ausbildung von Inhomogenitäten infolge von Ausdiffusion von Komponenten und Kontaminationen durch eindiffundierende Verunreinigungen vermieden werden.

Ein besonders kompakte Netzwerkstruktur ergibt sich, wenn die erste Abkühlrate zwischen 1 °C/h und 10 °C/h, und vorzugsweise auf einen Wert im Bereich zwischen 3° bis 5°C/h, eingestellt wird.

Im Hinblick auf eine kompakte Glasstruktur hat es sich auch als günstig erwiesen, wenn die zweite Abkühlrate im Bereich zwischen 25° und 80° C/h, vorzugsweise oberhalb von 40 °C/h eingestellt wird.

Je schneller der Abkühlvorgang erfolgt, umso größer sind die oben erwähnten Vorteile hinsichtlich Zeitersparnis, Verminderung von Diffusionseffekten und die Wirkung der "vorab kompaktierten" Glasstruktur.

In einer bevorzugten Ausführungsform des erfindungsgemäßen Verfahrens beträgt die zweite Haltezeit zwischen 1 Stunde und 16 Stunden.

Dem Quarzglas wird hierbei noch einmal Gelegenheit zur Relaxation gegeben. Die Temperaturverteilung innerhalb des Quarzglasrohlings wird homogenisiert und thermische Gradienten, die zu Spannungsdoppelbrechung führen, werden verringert.

In dem Zusammenhang und auch im Hinblick auf eine möglichst rasche Einstellung einer Glasstruktur, die nahe an der vorgegebenen fiktiven Temperatur liegt, beträgt die erste Haltezeit maximal 50 Stunden.

Vorteilhafterweise erfolgt das Beladen des Quarzglasrohlings mit Wasserstoff bei einem Druck zwischen 1 und 150 bar.

Ein erhöhter Druck beschleunigt die Wasserstoffbeladung und kann sich auch auf die Dichte im Sinne einer kompakteren und gegen lokale anisotrope Dichteänderung resistenteren Netzwerkstruktur auswirken.

Im Hinblick auf eine geringe Bildung von SiH-Gruppen wird eine Verfahrensweise bevorzugt, bei der das Beladen des Quarzglasrohlings mit Wasserstoff bei einer Temperatur unterhalb von 400°C, vorzugsweise unterhalb von 350 °C erfolgt.

Das erfindungsgemäße optische Quarzglas-Bauteil bzw. das nach dem erfindungsgemäßen Verfahren hergestellte optische Bauteil zeichnet sich durch eine geringe Empfindlichkeit für eine lokale anisotrope Dichteänderung bei Bestrahlung mit kurzwelliger UV-Strahlung aus. Es wird daher vorzugsweise als optisches Bauteil in einem Projektionssystem eines Belichtungsautomaten für die Immersions-Lithographie zum Zweck der Übertragung von ultravioletter, gepulster und linear polarisierter UV-Laserstrahlung einer Wellenlänge zwischen 190 nm und 250 nm eingesetzt.

Dabei hat es sich das Quarzglas-Bauteil als besonders stabil gegenüber UV-Laserstrahlung dieser Wellenlänge erwiesen, wenn diese eine Energiedichte von weniger als 300 µJ/cm², vorzugsweise weniger als 100 µJ/cm² und eine zeitliche Pulsbreite von 50 ns oder höher, vorzugsweise von 150 ns oder höher aufweist.

Nachfolgend wird die Erfindung anhand von Ausführungsbeispielen und einer Zeichnung näher erläutert. In der Zeichnung zeigen
- **Figur 1**: ein Diagramm zur Abhängigkeit der durch UV-Strahlung induzierten Doppelbrechung von der Energiedosis (Energiedichte x Pulszahl) der Strahlung,
- **Figur 2**: ein Diagramm zur Abhängigkeit der durch UV-Strahlung induzierten Doppelbrechung (Steigung der Geraden von Figur 1) vom Hydroxylgruppengehalt des Quarzglases,
- **Figur 3**: ein Diagramm zur Abhängigkeit der durch UV-Strahlung induzierten Doppelbrechung von der Pulszahl der Strahlung bei zwei Quarzglas-Qualitäten, die sich in ihrer fiktiven Temperatur unterscheiden,
- **Figur 4**: eine Graphik zur Erläuterung der isotropen und der anisotropen Dichteänderung bei UV-Bestrahlung.

### Probenherstellung

Es wird ein Sootkörper durch Flammenhydrolyse von SiCl₄ anhand des bekannten VAD-Verfahrens hergestellt. Der Sootkörper wird bei einer Temperatur von 1200 °C in einer chlorhaltigen Atmosphäre dehydratisiert und anschließend bei einer Temperatur von ca. 1750 °C unter Vakuum (10⁻² mbar) zu einem transparenten Quarzglasrohling verglast. Dieser wird anschließend durch thermisch mechanische Homogenisierung (Verdrillen) und Bildung eines Quarzglas-Zylinders homogenisiert. Der Quarzglas-Zylinder hat danach einen OH-Gehalt um 250 Gew.-ppm.

### Probe 1

Zum Abbau mechanischer Spannungen und zur Verminderung der Doppelbrechung sowie zur Erzeugung einer kompaktierungsresistenten Glasstruktur wird der Quarzglas-Zylinder einer Temperbehandlung unterzogen, die sich insbesondere durch ihre Kürze auszeichnet. Hierbei wird der Quarzglas-Zylinder während einer Haltezeit von 8 Stunden unter Luft und Atmosphärendruck auf 1130 °C erhitzt und anschließend mit einer Abkühlrate von 4 °C/h auf eine Temperatur von 1030 °C abgekühlt und bei dieser Temperatur 4 Stunden lang gehalten. Daraufhin wird der Quarzglas-Zylinder mit einer höheren Abkühlrate von 50 °C/h auf eine Temperatur von 300 °C abgekühlt, woraufhin der Ofen abgestellt und der Quarzglas-Zylinder der freien Abkühlung des Ofens überlassen wird.

Der so behandelte Quarzglaszylinder hat einen Außendurchmesser von 350 mm und eine Dicke von 60 mm. Das Quarzglas hat eine mittlere fiktive Temperatur von 1035°C. Es zeigt sich, dass der Zylinder vermutlich infolge des raschen Abkühlens von der Temperatur von 1030 °C besonders in seinen Randbereichen eine relativ starke Spannungsdoppelbrechung aufweist. Von den Stirnflächen des Quarzglaszylinders wird vor dem nächsten Behandlungsschritt ein Teil des Übermaßes gegenüber der Bauteil-Kontur abgenommen, nämlich eine Dicke von 3 mm.

Danach wird der Quarzglaszylinder in einer reinen Wasserstoffatmosphäre bei 380 °C zunächst bei einem Druck von 10 bar während einer Dauer von 22 Stunden, und danach bei einem Druck von 0,07 bar während einer Dauer von 816 Stunden gehalten.

Der danach erhaltene Quarzglaszylinder ist im Wesentlichen frei von Sauerstoffdefektstellen und SiH-Gruppen (unterhalb der Nachweisgrenze von 5 x10¹⁶ Molekülen/cm³), und er zeichnet sich innerhalb einem Durchmesser von 280 mm (CA-Bereich) durch einen mittleren Wasserstoffgehalt von 2 x 10¹⁶ Molekülen/cm³ (außerhalb davon etwa 3,6 x 10¹⁵ Moleküle/cm³), einen Hydroxylgruppengehalt von 250 Gew.-ppm sowie eine mittlere fiktive Temperatur von 1035 °C aus. Dem Quarzglas wird Fluor nicht zudotiert; der Fluorgehalt liegt unterhalb 1 Gew.-ppm.

### Probe 2

Ein anderer Quarzglas-Zylinder wurde wie oben anhand Probe 1 beschrieben hergestellt, jedoch erfolgte die Wasserstoffbeladung des Quarzglaszylinders in einer reinen Wasserstoffatmosphäre in einem ersten Verfahrensschritt bei 340 °C und bei einem Druck von 10 bar während einer Dauer von 8 Stunden, und in einem zweiten Verfahrensschritt bei 340 °C, bei einem Druck von 0,007 bar und während einer Dauer von 1570 Stunden.

Der danach erhaltene Quarzglaszylinder ist im Wesentlichen frei von Sauerstoffdefektstellen und SiH-Gruppen (unterhalb der Nachweisgrenze von 5 x 10¹⁶ Molekülen/cm³), und er zeichnet sich innerhalb einem Durchmesser von 280 mm (CA-Bereich) durch einen mittleren Wasserstoffgehalt von etwa 2 x 10¹⁵ Molekülen/cm³ (außerhalb davon etwa 3 x 10¹⁵ Moleküle/cm³), einen Hydroxylgruppengehalt von 250 Gew.-ppm sowie eine mittlere fiktive Temperatur von 1035 °C aus. Dem Quarzglas wird Fluor nicht zudotiert; der Fluorgehalt liegt unterhalb 1 Gew.-ppm.

### Probe 3

Ein anderer Quarzglas-Zylinder wurde wie oben anhand Probe 1 beschrieben - inklusive der Wasserstoffbeladung - hergestellt, jedoch erfolgte die Temperbehandlung mit folgendem Heizprogramm: Der Quarzglas-Zylinder wird während einer Haltezeit von 8 Stunden unter Luft und Atmosphärendruck auf 1250 °C erhitzt und anschließend mit einer Abkühlrate von 4 °C/h auf eine Temperatur von 1130 °C abgekühlt und bei dieser Temperatur 4 Stunden lang gehalten. Daraufhin wird der Quarzglas-Zylinder mit einer höheren Abkühlrate von 70 °C/h auf eine Temperatur von 300 °C abgekühlt, woraufhin der Ofen abgestellt und der Quarzglas-Zylinder der freien Abkühlung des Ofens überlassen wird.

Nach der Wasserstoffbeladung des Quarzglaszylinders ist dieser im Wesentlichen frei von Sauerstoffdefektstellen und SiH-Gruppen (unterhalb der Nachweisgrenze von 5 x10¹⁶ Molekülen/cm³), und er zeichnet sich durch einen Wasserstoffgehalt von 2 x 10¹⁶ Molekülen/cm³ und einen Hydroxylgruppengehalt von 250 Gew.-ppm sowie eine mittlere fiktive Temperatur von 1115 °C aus.

### Probe 4

Es wird ein Sootkörper durch Flammenhydrolyse von SiCl₄ anhand des bekannten VAD-Verfahrens hergestellt, wie oben erläutert. Der Sootkörper wird bei einer Temperatur von 1200 °C in einer chlorhaltigen Atmosphäre dehydratisiert und anschließend bei einer Temperatur von ca. 1750 °C unter Vakuum (10⁻² mbar) zu einem transparenten Quarzglasrohling verglast, der einen Hydroxylgruppengehalt von 120 Gew.-ppm aufweist. Der im Vergleich zu den Proben 1 bis 3 geringere Hydroxylgruppengehalt resultiert allein aus einer längeren Dehydratationsbehandlung. Der Quarzglasrohling wird anschließend unter Bildung eines Quarzglas-Zylinders mit einem OH-Gehalt um 120 Gew.-ppm homogenisiert.

### Messergebnisse

Aus den so hergestellten Quarzglaszylindern werden Messproben für die Ermittlung der Resistenz des Quarzglases gegenüber Bestrahlung mit linear polarisierter UV-Excimerlaserstrahlung einer Wellenlänge von 193 nm gefertigt.

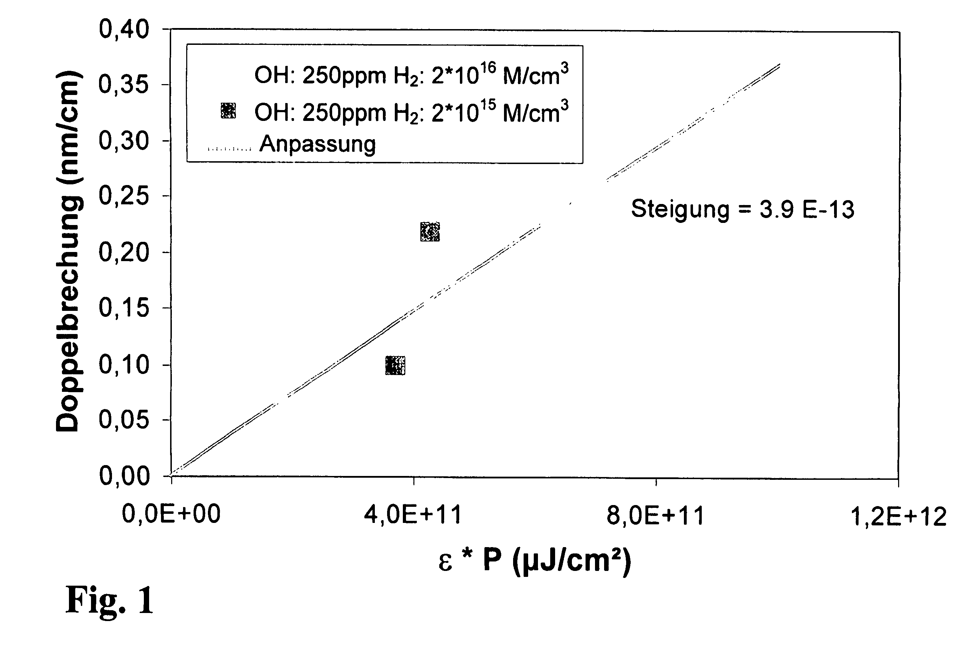

Ein Ergebnis dieser Messung ist in **Figur 1** dargestellt. Für die Proben 1 und 2 ist hier auf der Y-Achse die Doppelbrechung in nm/cm, und auf der X-Achse eine die Energie der eingestrahlten UV-Strahlung charakterisierender Parameter, nämlich das Produkt aus der Energiedichte der UV-Strahlung in µJ/cm² und der Pulszahl, aufgetragen.

Demnach nimmt sowohl bei der Probe mit einem geringen Wasserstoffgehalt (2 x 10¹⁵ Moleküle/cm³) als auch bei der Probe mit einem höheren Wasserstoffgehalt (3 x 10¹⁶ Moleküle/cm³) die Doppelbrechung mit zunehmendem Produkt ε x P etwa linear zu. Die Steigung der Geraden beträgt etwa 3,9 x 10⁻¹³, und sie ist ein Maß für die Empfindlichkeit des Quarzglases gegenüber linear polarisierter UV-Strahlung in Bezug auf anisotrope Veränderungen seiner Dichte.

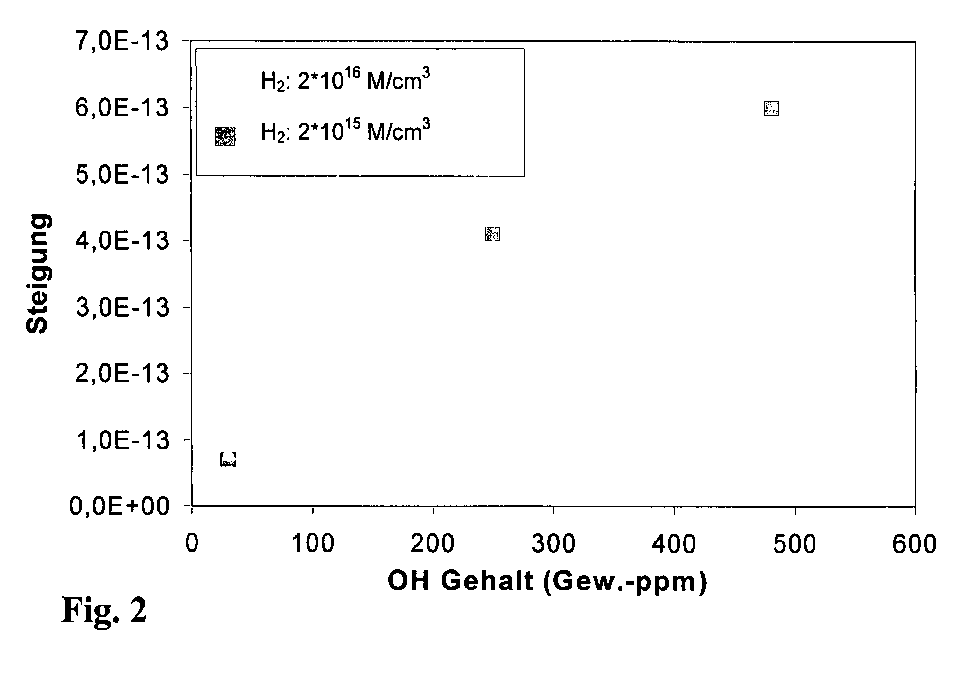

Entsprechende Versuche wurden für weitere Quarzglasproben durchgeführt, die einen Hydroxylgruppengehalt von 30 Gew.-ppm bzw. von etwa 480 Gew.-ppm aufwiesen und ansonsten den Proben 1 und 2 entsprechen. Die Versuchsergebnisse sind im Diagramm von **Figur 2** zusammengefasst. Hier ist auf der Y-Achse jeweils die Steigung der Geraden aufgetragen, wie sie für die Proben 1 und 2 anhand der Figur 1 dargestellt ist. Die X-Achse zeigt den jeweiligen OH-Gehalt der Proben in Gew.-ppm.

Es ist deutlich zu erkennen, dass im Wesentlichen unabhängig vom Wasserstoffgehalt der Probe die Steigung stark mit dem OH-Gehalt skaliert. Das bedeutet, dass mit zunehmendem OH-Gehalt die Empfindlichkeit der Quarzglasproben in Bezug auf eine anisotrope Dichteänderung bei Bestrahlung mit linear polarisierter Laserlicht-Strahlung einer Wellenlänge von 193 nm stark zunimmt. Die entsprechende Resistenz der Quarzglasproben 1 und 2 (mit einem OH-Gehalt von 250 Gew.-ppm) kann gerade noch als akzeptabel angesehen werden. Bei höheren OH-Gehalten erscheint die Empfindlichkeit des Quarzglases gegenüber einer anisotropen Dichteänderung jedoch nicht mehr akzeptabel. Die beste Resistenz wurde bei den Messproben aus Quarzglas mit einem OH-Gehalt von 30 Gew.-ppm gefunden.

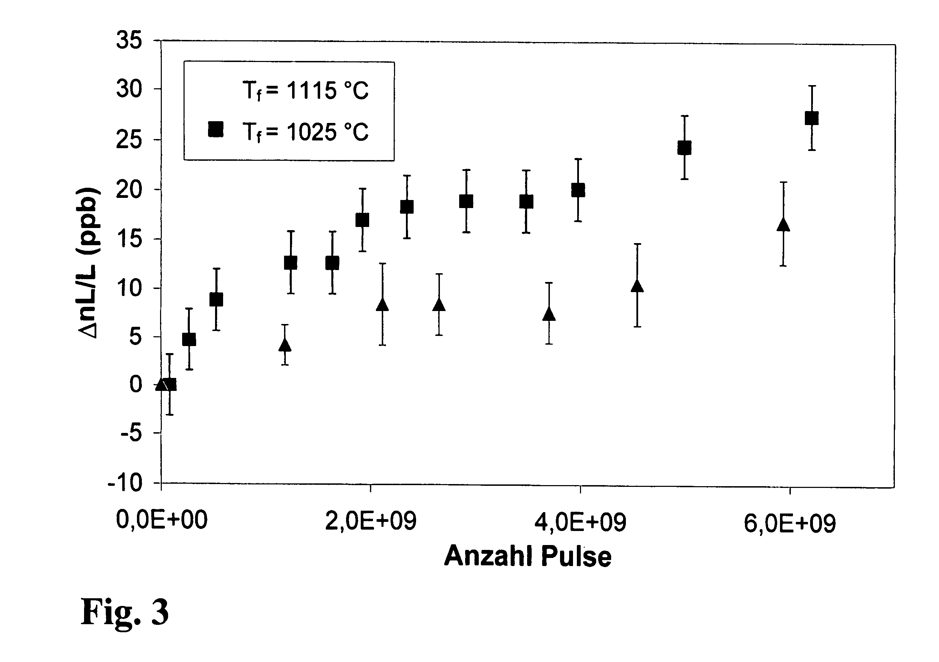

Das Diagramm von **Figur 3** zeigt die Wellenfrontverzerrung, angegeben als Änderung des Brechungsindex bezogen auf die Weglänge ΔnL/L in ppb, in Abhängigkeit von der Pulszahl bei Bestrahlung zweier unterschiedlicher Quarzglasproben (Probe 1 und Probe 3), die sich in Bezug auf ihre fiktive Temperatur unterscheiden. Diese Proben wurden linear polarisierter UV-Strahlung einer Wellenlänge von 193 nm, mit einer Pulsbreite von 25 ns und einer Energiedichte von 35 µJ/cm² ausgesetzt und die dabei erzeugte Wellenfrontverzerrung von Zeit zu Zeit gemessen.

Daraus ist erkennbar, dass die Wellenfrontverzerrung mit zunehmender Pulszahl nach einem anfänglich steilen Anstieg in einen deutlichen flacheren Anstieg übergeht, wobei das Niveau der Wellenfrontverzerrung bei der Probe 3 mit der hohen fiktiven Temperatur deutlich niedriger liegt als bei der Probe 1 mit der geringeren fiktiven Temperatur. Dies zeigt, dass der isotrope Anteil der Dichteänderung durch linear polarisierte Strahlung von der fiktiven Temperatur des jeweiligen Quarzglases abhängt, und dass dieser bei der Probe mit der hohen fiktiven Temperatur niedriger ausfällt als bei der Probe mit der geringen fiktiven Temperatur.

Optische Bauteile, die aus einem Quarzglasqualität entsprechend den Proben 1 bis 3 hergestellt sind (mit einem Hydroxylgruppengehalt um 250 Gew.-ppm), sind für den Einsatz in einem Projektionssystem eines Belichtungsautomaten für die Immersions-Lithographie zum Zweck der Übertragung von ultravioletter, gepulster und linear polarisierter UV-Laserstrahlung einer Wellenlänge zwischen 190 nm und 250 nm besonders geeignet. Noch bessere Ergebnisse sind jedoch zu erwarten, wenn der Hydroxylgruppengehalt unterhalb von 200 Gew.-ppm liegt, vorzugsweise unterhalb von 125 Gew.-ppm, wie bei der Probe 4.

Erste Versuche zur Überprüfung der Abhängigkeit der anisotropen Strahlenschädigung von der Pulsweite des eingestrahlten Laserlichtes lassen vermuten, dass das Quarzglas des erfindungsgemäßen Bauteils gegenüber Pulsen mit einer Pulsweite von 50 ns eine verbesserte Resistenz aufweist (im Vergleich zu einer Pulsweite von 25 ns). Eine weitere Verbesserung der Strahlenresistenz zeigte sich gegenüber Bestrahlung mit Pulsweiten von 150 ns.

## Patentansprüche

1. Optisches Bauteil aus Quarzglas zur Übertragung ultravioletter Strahlung einer Wellenlänge zwischen 190 nm und 250 nm, mit einer Glasstruktur im wesentlichen ohne Sauerstoffdefektstellen, einem Wasserstoffgehalt im Bereich von 0,1 x 10¹⁶ Molekülen/cm³ bis 5,0 x 10¹⁶ Molekülen/cm³, und mit einem Gehalt an SiH-Gruppen von < 5 x 10¹⁶ Molekülen/cm³, **dadurch gekennzeichnet, dass** das Quarzglas einen Gehalt an Hydroxylgruppen im Bereich zwischen 10 und maximal 250 Gew.-ppm und eine fiktiven Temperatur von 1035 °C oder höher aufweist.

2. Optisches Bauteil nach Anspruch 1, **gekennzeichnet durch** eine fiktive Temperatur oberhalb von 1050 °C, vorzugsweise oberhalb von 1100 °C.

3. Optisches Bauteil nach Anspruch 1 oder Anspruch 2, **gekennzeichnet durch** einen Gehalt an Hydroxylgruppen zwischen 30 bis 200 Gew.-ppm, vorzugsweise unterhalb von 125 Gew.-ppm.

4. Optisches Bauteil nach einem der vorhergehenden Ansprüche, **gekennzeichnet durch** einen Gehalt an Fluor unterhalb von 100 Gew.-ppm.

5. Verfahren zur Herstellung eines optischen Bauteils aus Quarzglas nach einem der vorhergehenden Ansprüche, umfassend die folgenden Verfahrensschritte:
• Herstellen eines SiO₂-Sootkörpers,
• Verglasen des Sootkörpers unter Vakuum unter Bildung eines zylinderförmigen Quarzglasrohlings mit einem Hydroxylgruppengehalt im Bereich zwischen 10 und maximal 250 Gew.-ppm, vorzugsweise zwischen 30 bis 200 Gew.-ppm, und besonders bevorzugt unterhalb von 125 Gew.-ppm.
• Tempern des Quarzglasrohlings unter Bildung eines Quarzglas-Zylinders, mit einer fiktiven Temperatur von 1035 °C oder höher, der eine Kontur des herzustellenden optischen Bauteils mit Übermaß umgibt, wobei das Tempern ein Halten des Quarzglasrohlings während einer ersten Haltezeit von mindestens 4 Stunden bei einer ersten, höheren Tempertemperatur, die mindestens 50 °C oberhalb der einzustellenden fiktiven Temperatur des Quarzglas-Bauteils liegt, ein Abkühlen mit einer ersten, geringeren Abkühlrate auf eine zweite, niedrigere Tempertemperatur, die im Bereich zwischen +/- 20 °C um die einzustellende fiktiven Temperatur des Quarzglas-Bauteils liegt, ein Halten bei der niedrigeren Tempertemperatur während einer zweiten Haltezeit, und ein Abkühlen auf eine vorgegebene Endtemperatur unterhalb von 800 °C, vorzugsweise unterhalb von 400 °C, mit einer zweiten, höheren Abkühlrate, die mindestens 25°C/h beträgt, umfasst,
• Abnehmen eines Teils des axialen Übermaßes im Bereich der Stirnflächen des Quarzglas-Zylinders,
• Beladen des Quarzglas-Zylinders mit Wasserstoff durch Erhitzen in einer Wasserstoff enthaltenden Atmosphäre bei einer Temperatur unterhalb von 500 °C unter Erzeugung eines mittleren Wasserstoffgehalts im Bereich von 0,1 x 10¹⁶ Molekülen/cm³ bis 5,0 x 10¹⁶ Molekülen/cm³.

6. Verfahren nach Anspruch 5, **dadurch gekennzeichnet, dass** die erste Abkühlrate im Bereich zwischen 1 °C/h und 10 °C/h, vorzugsweise auf einen Wert im Bereich zwischen 3° bis 5°C/h eingestellt wird.

7. Verfahren nach Anspruch 5 oder 6, **dadurch gekennzeichnet, dass** die zweite Abkühlrate im Bereich zwischen 25° und 80° C/h, vorzugsweise oberhalb von 40 °C/h liegt.

8. Verfahren nach einem der Ansprüche 5 bis 7, **dadurch gekennzeichnet, dass** die zweite Haltezeit zwischen 1 Stunde und 16 Stunden beträgt.

9. Verfahren nach einem der Ansprüche 5 bis 8, **dadurch gekennzeichnet, dass** die erste Haltezeit maximal 50 Stunden beträgt.

10. Verfahren nach einem der vorhergehenden Ansprüche 5 bis 9, **dadurch gekennzeichnet, dass** das Beladen des Quarzglasrohlings mit Wasserstoff bei einem Druck zwischen 1 und 150 bar erfolgt.

11. Verfahren nach einem der vorhergehenden Ansprüche 5 bis 10, **dadurch gekennzeichnet, dass** das Beladen des Quarzglasrohlings mit Wasserstoff bei einer Temperatur unterhalb von 400°C, vorzugsweise unterhalb von 350 °C erfolgt.

12. Verwendung eines optischen Bauteils nach einem der Ansprüche 1 bis 4 oder eines nach dem Verfahren gemäß den Ansprüchen 5 bis 11 hergestellten optischen Bauteils aus Quarzglas in einem Projektionssystem eines Belichtungsautomaten für die Immersions-Lithographie zum Zweck der Übertragung von ultravioletter, gepulster und linear polarisierter UV-Laserstrahlung einer Wellenlänge zwischen 190 nm und 250 nm.

13. Verwendung nach Anspruch 12, **gekennzeichnet durch** einer Energiedichte der Laserstrahlung von weniger als 300 µJ/cm², vorzugsweise weniger als 100 µJ/cm².

14. Verwendung nach Anspruch 12 oder 13, **gekennzeichnet durch** einer zeitliche Pulsbreite der Laserstrahlung von 50 ns oder mehr, vorzugsweise von 150 ns oder mehr.

## Claims

1. An optical component of quartz glass for transmitting ultraviolet radiation of a wavelength between 190 nm and 250 nm, with a glass structure essentially without oxygen defects, a hydrogen content ranging from 0.1 x 10¹⁶ molecules/cm³ to 5.0 x 10¹⁶ molecules/cm³, and with a content of SiH groups of < 5 x 10¹⁶molecules/cm³, **characterized in that** the quartz glass has a content of hydroxyl groups ranging from 10 to 250 wt ppm and a fictive temperature of 1035°C or above.

2. The optical component according to claim 1, **characterized by** a fictive temperature above 1050°C, preferably above 1100°C.

3. The optical component according to claim 1 or claim 2, **characterized by** a content of hydroxyl groups between 30 and 200 wt ppm, preferably below 125 wt ppm.

4. The optical component according to any one of the preceding claims, **characterized by** a content of fluorine below 100 wt ppm.

5. A method for producing an optical component of quartz glass according to any one of the preceding claims, comprising the following steps:
• producing an SiO₂ soot body,
• vitrifying the soot body under vacuum with formation of a cylindrical quartz glass blank with a hydroxyl group content ranging between 10 and 250 wt ppm, preferably between 30 and 200 wt ppm, and particularly preferably below 125 wt ppm,
• annealing the quartz glass blank with formation of a quartz glass cylinder, with a fictive temperature of 1035°C or above, which surrounds a contour of the optical component to be produced with an overdimension, whereby annealing comprises a holding the quartz glass blank for a first holding period of at least 4 hours at a first higher annealing temperature which is at least 50°C above the fictive temperature of the quartz glass component to be set, a cooling at a first lower cooling rate to a second lower annealing temperature which is in the range between +/- 20 °C around the fictive temperature of the quartz glass component to be set, a holding at the lower annealing temperature for a second holding period, and a cooling to a predetermined final temperature below 800°C, preferably below 400°C, at a second higher cooling rate which is at least 25°C/h.
• removing part of the axial overdimension in the area of the faces of the quartz glass cylinder,
• loading the quartz glass cylinder with hydrogen by heating in a hydrogencontaining atmosphere at a temperature below 500°C with generation of a mean hydrogen content in the range of 0.1 x 10¹⁶ molecules/cm³ to 5.0 x 10¹⁶ molecules/cm³.

6. The method according to claim 5, **characterized in that** the first cooling rate is set in the range between 1°C/h and 10°C/h, preferably to a value in the range between 3° and 5°C/h.

7. The method according to claim 5 or 6, **characterized in that** the second cooling rate is in the range between 25° and 80°C/h, preferably above 40°C/h.

8. The method according to any one of claims 5 to 7, **characterized in that** the second holding time is between 1 hour and 16 hours.

9. The method according to any one of claims 5 to 8, **characterized in that** the first holding time is not more than 50 hours.

10. The method according to any one of the preceding claims 5 to 9, **characterized in that** the quartz glass blank is loaded with hydrogen at a pressure between 1 and 150 bar.

11. The method according to any one of the preceding claims 5 to 10, **characterized in that** the quartz glass blank is loaded with hydrogen at a temperature below 400°C, preferably below 350°C.

12. Use of an optical component according to any one of claims 1 to 4 or of an optical component of quartz glass produced according to the method according to claims 5 to 11, in a projection system of an automatic exposure machine for immersion lithography for the purpose of transmitting ultraviolet, pulsed and linearly polarized UV laser radiation of a wavelength between 190 nm and 250 nm.

13. Use according to claim 12, **characterized by** an energy density of the laser radiation of less than 300 µJ/cm², preferably less than 100 µJ/cm².

14. Use according to claim 12 or 13, **characterized by** a pulse width of the laser radiation in time of 50 ns or more, preferably 150 ns or more.

## Revendications

1. Composant optique en verre de quartz pour la transmission de rayonnement ultraviolet d'une longueur d'onde comprise entre 190 nm et 250 nm, avec une structure de verre sans défauts d'oxygène, une teneur en hydrogène comprise entre 0,1 x 10¹⁶ molécules /cm³ et 5,0 x 10¹⁶ molécules/cm³, et une teneur en groupes SiH < 5 x 10¹⁶ molécules/cm³, **caractérisé en ce que** le verre de quartz présente une teneur en groupes hydroxyles comprises entre 10 et maximal 250 ppm en poids et une température fictive supérieure ou égale à 1035°C.

2. Composant optique selon la revendication 1, **caractérisé par** une température fictive supérieure à 1050°C, de préférence supérieure à 1100°C.

3. Composant optique selon la revendication 1 ou la revendication 2, **caractérisé par** une teneur en groupes hydroxyles comprise entre 30 et 200 ppm en poids, de préférence inférieure à 125 ppm en poids.

4. Composant optique selon l'une des revendications précédentes, **caractérisé par** une teneur en fluor inférieure à 100 ppm en poids.

5. Procédé pour la fabrication d'un composant optique en verre de quartz selon l'une des revendications précédentes comprenant les étapes de procédés suivantes:
• fabrication d'un corps de suie SiO₂,
• vitrification du corps de suie sous vide par formation d'une ébauche de verre de quartz cylindrique dont la teneur en groupes hydroxyle est comprise entre 10 et maximale 250 ppm en poids, de préférence entre 30 et 200 ppm en poids et en particulier de préférence inférieure à 125 ppm en poids,
• recuit de l'ébauche de verre de quartz en formant un cylindre de verre de quartz avec une température fictive égale ou supérieure à 1035°C ou supérieure qui entoure un contour du composant optique à fabriquer avec une surdimension, la recuit comprenant le maintien de l'ébauche de verre pendant au moins 4 heures à une première température de recuit plus élevée qui est au moins de 50°C au-dessus de la température fictive à régler, du composant de verre de quartz, un refroidissement avec une première vitesse plus faible de refroidissement à une seconde température de recuit plus basse qui se situe dans la plage entre +/- 20°C de la température fictive à régler du composant de verre, un maintien à la température de recuit plus basse pendant une seconde période de maintien à une température finale inférieure à 800°C, de préférence inférieure à 400°C, avec une seconde vitesse de refroidissement plus élevée qui est d'au moins 25°C/h,
• Retrait d'une partie de la surdimension axiale dan la zone des surfaces frontales du cylindre de quartz,
• Chargement du cylindre de verre de quartz en hydrogène par chauffage dans une atmosphère contenant de l'hydrogène à une température inférieure à 500°C en générant une teneur en hydrogène moyenne comprise entre 0,1 x 10¹⁶ Molécules/cm³ et 5,0 x 10¹⁶ Molécules/cm³.

6. Procédé selon la revendication 5, **caractérisé en ce que** la première vitesse de refroidissement est réglée dans une plage comprise entre 1°C/h et 10°C/h, de préférence à une valeur comprise entre 3°C/h et 5°C/h.

7. Procédé selon la revendication 5 ou 6, **caractérisé en ce que** la seconde vitesse de refroidissement est comprise entre 25° et 80° C/h, de préférence 40° C/h.

8. Procédé selon l'une des revendications 5 à 7, **caractérisé en ce que** la seconde période de maintien est comprise entre 1 heure et 16 heures.

9. Procédé selon l'une des revendications 5 à 8, **caractérisé en ce que** la première période de maintien est de maximum 50 heures.

10. Procédé selon l'une des revendications 5 à 9, **caractérisé en ce que** le chargement de l'ébauche de verre de quartz en hydrogène s'effectue à une pression comprise entre 1 et 150 bars.

11. Procédé selon l'une des revendications précédentes 5 à 10, **caractérisé en ce que** le chargement de l'ébauche de verre de quartz en hydrogène s'effectue à une température inférieure à 400°C, de préférence inférieure à 350°C.

12. Utilisation d'un composant optique selon l'une des revendications 1 à 4 ou d'un composant optique fabriqué selon le procédé conforme aux revendications 5 à 11, en verre de quartz dans un système de projection d'un appareil automatique d'exposition pour la lithographie en immersion dans le but d'une transmission de rayonnement laser UV ultraviolet, linéairement polarisé et pulsé d'une longueurs d'onde comprise entre 190 nm et 250 nm.

13. Utilisation selon la revendication 12, **caractérisée par** une densité énergétique du rayonnement laser inférieure à 300 µJ/cm², de préférence inférieure à 100 µJ/cm².

14. Utilisation selon la revendication 12 ou 13, **caractérisée par** une largeur d'impulsion du rayonnement laser égale ou supérieure à 50 ns, de préférence égale ou supérieure à 150 ns.
